# FASCICULE DE BREVET EUROPEEN

(11) **EP 2 992 141 B1**
(45) Date de publication et mention de la délivrance du brevet: **28.02.2018**
(21) Numéro de dépôt: 14721333.4
(22) Date de dépôt: 29.04.2014
(51) Int. Cl.: D21H 13/40, D21H 17/33, D21H 17/34, D21H 19/20, D21H 19/72, D21H 19/76, D21H 19/78, D21H 21/16, H05K 1/03, D21H 19/82

(54) **SUPPORT PLAN HYDROPHOBE**
HYDROPHOBE AUFLAGEFLÄCHE
HYDROPHOBIC PLANAR SUPPORT

(30) Priorité: 02.05.2013 FR 1354064
(43) Date de publication de la demande: 09.03.2016
(73) Titulaire: Arjo Wiggins Fine Papers Limited, Manchester M1 SES (GB)
(72) Inventeur: DEPRES, Gaël, F-38850 Chirens (FR); VAU, Jean-Marie, F-75012 Paris (FR)
(74) Mandataire: Desaix, Anne
(86) Numéro de dépôt international: PCT/EP2014/058762
(87) Numéro de publication internationale: WO 2014/177586

(56) Documents cités:
- WO-A1-97/39036
- WO-A1-2010/086511
- WO-A1-2011/093896
- US-A- 3 811 933

## Description

La présente invention concerne un support plan hydrophobe, un circuit imprimé réalisé à partir d'un tel support, et un procédé de fabrication de ce support. En particulier un support plan hydrophobe selon l'invention est réalisé à base de papier.

Afin de réaliser un support en papier selon l'invention, les techniques papetières connues de l'homme du métier peuvent être mises en oeuvre. Un procédé connu consiste à préparer dans un pulpeur une pâte homogène par mélange de fibres cellulosiques, d'eau et d'un liant. Le pulpeur permet le brassage et le cisaillage des fibres, de façon à les séparer et à les individualiser en vue de former une suspension fibreuse.

La pâte passe ensuite au travers d'un raffineur. Ce dernier comporte un stator et un rotor tournant à grande vitesse, équipés de dents ou de stries radiales. La pâte circule entre le rotor et le stator du raffineur de façon à modifier la structure de la paroi des fibres pour introduire de l'eau à l'intérieur des fibres, en vue de couper les fibres et/ou d'augmenter la fibrillation et par conséquent le potentiel de liaison entre les fibres.

La composition de la pâte peut alors être ajustée avant d'être envoyée dans la caisse de tête d'une machine à papier.

La caisse de tête permet de répartir uniformément la pâte sur une toile en mouvement d'une table plate (dans le cas d'une machine Fourdrinier), où elle va subir un égouttage au travers des mailles de la toile, par gravité et par aspiration à l'aide de caisses aspirantes, en vue de réaliser une feuille. Un feutre est généralement appliqué sur la feuille, à l'opposé de la toile. En sortie de la table plate, la feuille contient encore une grande quantité d'eau.

Lors de cette étape, les fibres s'orientent majoritairement dans le sens de déplacement de la toile, appelé sens marche. On définit par sens travers, la direction perpendiculaire au sens marche. En outre, la face de la feuille qui est appliquée contre la toile (côté toile) présente en général une rugosité plus importante que la face opposée (côté feutre).

Il existe également des machines à papier dites à double toile, comportant deux toiles opposées, appliquées de part et d'autre de la feuille. L'eau peut être évacuée par aspiration au travers de chacune des toiles.

Une fois formée la feuille de papier, celle-ci traverse la section de presse de la machine à papier, afin de retirer d'avantage d'eau. Pour cela, la feuille passe entre une série de cylindres compressant la feuille afin d'en extraire de l'eau. Lors de cette étape, la feuille de papier est également prise en sandwich entre des feutres absorbants se présentant sous la forme de ceintures sans fin, des caisses aspirantes permettant de retirer l'eau absorbée par les feutres à l'issue du pressage de la feuille, avant que les feutres ne soient à nouveau appliqués contre la feuille.

La feuille traverse alors une sécherie composée d'une série de cylindres chauffés à la vapeur, sur lesquels passe la feuille. La température des cylindres augmente progressivement, d'amont en aval par rapport au sens de déplacement de la feuille.

On définit par partie humide de la machine à papier, l'ensemble des éléments de la machine (caisse de tête, table plate) situés en amont de la sécherie.

Une fois que l'humidité de la feuille a été fortement réduite, et est par exemple de l'ordre de 5 %, la feuille peut subir un traitement d'encollage en surface par passage au travers d'une presse-encolleuse (« *size press* », en anglais). La presse-encolleuse est généralement formée de deux rouleaux disposés côte-à-côte, de manière à former une cuvette alimentée par une sauce d'une composition déterminée. La feuille passe entre les rouleaux de manière à enduire ses deux faces opposées, avec la sauce.

La feuille passe ensuite dans une section dite de post-sécherie, dans laquelle elle est à nouveau appliquée contre un ou plusieurs rouleaux chauffés à la vapeur.

A l'issue de ces différentes étapes la feuille se présente sous la forme d'une bande continue comportant une zone interne ou à coeur formant un matelas fibreux, dont les faces ou surfaces externes sont chacune recouvertes d'un enduit.

Cette feuille peut éventuellement subir des opérations de finition tels par exemple que le calandrage ou le lissage, afin d'améliorer l'état de surface de la feuille, avant d'être enroulée, coupée et conditionnée sous la forme de bobines par exemple.

Les surfaces des fibres cellulosiques utilisées pour la fabrication d'une telle feuille de papier peuvent présenter un caractère hydrophile qui n'est pas compatible, soit avec certaines étapes de fabrication de la feuille (traitement de surface, encollage à l'aide d'une presse encolleuse), soit avec certaines utilisations ultérieures de la feuille.

Afin de remédier à cet inconvénient, il est connu d'utiliser des agents de collage qui permettent de conférer à la feuille une certaine hydrophobicité. On distinguera deux types de collage, à savoir le collage en surface qui est un traitement de la surface externe de la feuille formée (à l'aide d'une presse-encolleuse, par exemple), et le collage en masse ou à coeur de la feuille.

Le collage en masse consiste à ajouter un ou plusieurs agents de collage à la suspension fibreuse avant la formation des feuilles de papier. L'ajout de ces agents de collage dans la suspension fibreuse modifie les propriétés des fibres de cellulose et rend la feuille hydrophobe à coeur.

Il existe plusieurs types d'agents de collage. Les agents de collage d'origine naturelle, tels que les résines de colophane, se fixent aux fibres cellulosiques par une liaison ionique via la formation d'un complexe avec des ions aluminium. De plus en plus, les résines de colophane ont été remplacées par des agents de collage synthétiques tels que l'alkyl cétène dimère (A.K.D. ou *alkyl ketene dimer*) et l'anhydride alkényle succinique (A.S.A. ou *alkenyl succinic anhydride*).

L'invention peut notamment s'appliquer au domaine technique des circuits imprimés.

Un circuit imprimé ou une carte électronique, également connu sous l'acronyme anglais P.C.B. (« *Printed Circuit Board* ») est un support comportant des pistes en matériau électriquement conducteur, reliées à des composants électroniques dans le but de réaliser un circuit électronique. Les pistes sont généralement obtenues par dépôt d'une couche de cuivre sur le support, ladite couche étant ensuite gravée par un procédé chimique nécessitant l'emploi d'un ou plusieurs bains dont les pH peuvent être relativement agressifs (procédé soustractif).

Le support et la couche de cuivre peuvent comporter des trous réalisés par exemple par perçage ou poinçonnage, permettant l'insertion des broches des composants électroniques et/ou la préhension du circuit imprimé lors sa fabrication par des moyens appropriés. Lorsque les composants électroniques utilisés sont de type montés en surface (C.M.S), ces composants sont directement brasés sur la surface des pistes conductrices. Des circuits imprimés flexibles sont réalisés afin de répondre à des besoins particuliers, de tels circuits imprimés comportant des supports se présentant sous la forme de films en polyimide sur lesquels sont collées des feuilles minces de cuivre. Des pistes conductrices sont ensuite gravées chimiquement dans les feuilles de cuivre.

De tels supports en matériau plastique ne sont pas recyclables et présentent un coût important.

Il a donc été envisagé de réaliser des circuits imprimés à l'aide de supports en papier. Le document « Foldable Printed Circuit Boards on Paper Boards » (Adam C. Siegel et al., Adv. Funct. Mater. 2010, 20, 28-35) décrit la réalisation de tels circuits imprimés par dépôt de métal sur un support papier, notamment par pulvérisation.

Les procédés actuels de dépôt de couches minces électriquement conductrices ne sont pas adaptés à des productions industrielles à grande série et à faibles coûts.

Afin de remédier aux inconvénients précités, l'invention propose un support recyclable et adapté notamment à la fabrication d'un circuit imprimé par un procédé soustractif tel que décrit ci-dessus.

A cet effet, elle propose un support plan hydrophobe, comportant un matelas fibreux à base de fibres cellulosiques et d'une résine fluorée conférant des propriétés hydrophobes au matelas fibreux, au moins une surface du matelas étant recouverte, au moins en partie, d'un enduit dont l'énergie de surface est supérieure à celle du matelas fibreux.

Dans un mode de réalisation particulier du support de l'invention, les deux surfaces du matelas fibreux sont, au moins en partie, recouvertes d'un enduit dont l'hydrophobicité est plus faible que celle du matelas fibreux.

En particulier, le support se présente sous la forme d'une feuille ou d'une bande.

Le support selon l'invention est ainsi très hydrophobe à coeur et moins hydrophobe en surface. Le caractère très hydrophobe du matelas fibreux permet notamment de pouvoir utiliser ce type de support dans un procédé soustractif de réalisation de circuits imprimés et requiert l'utilisation de bains chimiques ou l'élaboration du circuit imprimé à partir du matériau conducteur. On rappelle qu'un tel procédé permet de fabriquer des volumes importants de circuits imprimés, à faible coût. Dans ce cas, le support peut comporter des trous permettant l'engagement de broches pour des composants électriques ou permettant la préhension dudit support, sans qu'il soit attaqué chimiquement à coeur par des bains aux pH agressifs. En effet, le caractère hydrophobe du matelas fibreux permet de protéger celui-ci contre l'infiltration d'eau et d'ions au sein des pores du matelas fibreux, ce qui évite sa dégradation lors de son passage dans les bains chimiques.

Le fait que l'hydrophobicité de surface (c'est-à-dire de l'enduit externe) du support soit plus réduite permet l'encollage d'un matériau conducteur, notamment sous la forme d'une feuille, par exemple en cuivre, en aluminium ou en tout autre matériau, sur la surface externe du support. En effet, si l'hydrophobicité de surface est trop importante, la colle ne peut plus mouiller la surface de l'enduit, ce qui nuit à l'adhésion de la colle sur le support.

La colle utilisée peut être à base d'eau (amidon, colle polymère synthétique,...), à base solvant (PU, époxy) ou sans solvant (PU).

Le support selon l'invention est en outre aisément recyclable, léger et peut être courbé selon un rayon de courbure très faible. Un tel support est également déchirable, ce qui est utile pour des applications de sécurité.

La faible hydrophobicité de surface du support permet également son impression, par différentes techniques (jet d'encre, flexographie, sérigraphie, héliographie) dans le but de créer des circuits électriques. Les encres peuvent être de types conductrices (argent, or, cuivre, carbone, graphène, PEDOT/PSS....), semi-conductrices et/ou isolantes. Les dépôts sous vide sont également possibles (or, aluminium, argent....).

L'invention ne se limite pas à un support utilisable pour la réalisation de circuits imprimés. Un tel support peut en effet être utilisé pour des applications optiques (laminage d'un film en aluminium ou en polymère sur le support), tout en utilisant des bains chimiques de gravure. De manière générale, le support selon l'invention peut notamment être utilisé pour toutes les applications nécessitant un support capable de résister à une succession de bains chimiques.

Pour déterminer d'hydrophobicité du support selon l'invention, on peut mesurer l'énergie de surface de l'enduit (énergie de surface externe) et celle du matelas fibreux (énergie de surface interne).

Selon une caractéristique de l'invention, l'énergie de surface de l'enduit est comprise de 10 à 40 mJ/m², de préférence comprise de 15 à 30 mJ/m², plus préférentiellement de l'ordre de 17,5 mJ/m².

L'énergie de surface de l'enduit est mesurée à l'aide du test TAPPI T558, utilisant la mesure d'angle de contact. On rappelle que la mesure d'angle de contact rend compte de l'aptitude d'un liquide à s'étaler sur une surface par mouillabilité. Une telle méthode consiste à mesurer l'angle de la tangente du profil d'une goutte déposée sur la surface externe de l'enduit, avec la surface de l'enduit. On en déduit alors, par calcul, l'énergie de surface externe du support. Plus l'énergie de surface est élevée, plus l'hydrophobicité de l'enduit est faible.

La méthode de test peut utiliser deux liquides, à savoir l'eau et le diodométhane.

Dans ce cas, le test est successivement réalisé avec de l'eau et avec du diodométhane. L'énergie est ensuite calculée à partir des deux angles mesurés.

L'énergie de surface est calculée par la méthode d'Owens et Wendt.

Selon une autre caractéristique de l'invention, l'énergie de surface interne du matelas fibreux est comprise de 5 à 30 mJ/m², de préférence comprise de 10 à 20 mJ/m², plus préférentiellement de l'ordre de 12 mJ/m².

Plus l'énergie de surface est élevée, plus l'hydrophobicité du matelas fibreux est faible.

Afin de mesurer l'énergie de surface interne du matelas fibreux, on utilise de préférence une méthode comportant :
- une étape de délamination du support à coeur, à l'aide d'un appareil de type Scott Bond, afin de mesurer la cohésion interne, le support étant ainsi séparé en deux parties dans son épaisseur, au niveau du matelas fibreux
- une étape de calandrage d'une des deux parties ainsi obtenue sur une calandre en acier, en effectuant trois passages à 50 bars, afin de réduire la rugosité,
- une étape de mesure de l'énergie de surface à l'aide de la méthode décrite précédemment, utilisée pour la mesure de l'énergie de surface de l'enduit du support.

Dans un mode de réalisation particulier de l'invention, l'énergie de surface de l'enduit est de 17 mJ/m² ± 20 % et celle du matelas fibreux est de 12 mJ/m² ± 20 %.

Avantageusement, le matelas fibreux comporte des fibres cellulosiques courtes, de longueur moyenne comprise de 0,5 à 1,5 mm, telles que des fibres de bois issues d'eucalyptus ou d'autres feuillus, et des fibres cellulosiques longues, de longueur moyenne comprise de 1,5 à 3 mm, telles que des fibres de bois issues de résineux.

Les fibres d'eucalyptus peuvent être du type Cenibra. Les fibres de résineux peuvent être du type Sodra Black R.

Bien entendu, d'autres types de fibres peuvent également être utilisés. D'une manière générale, il est possible d'utiliser des fibres de cellulose de bois ou de plantes annuelles telles que les fibres de coton, bambou, paille, chanvre, lin, alpha, jute, des fibres recyclées, ou un mélange de fibres choisies parmi deux ou plus de deux types de fibres citées précédemment.

De préférence, le matelas fibreux comporte de 10 à 90 % en poids sec, de préférence 45,8% en poids sec de fibres courtes, et de 10 à 90 % en poids sec, de préférence 45,8% en poids sec de fibres longues.

Le matelas fibreux peut également comporter de 3 à 50 % en poids sec de fibres de verre, de préférence 7,5 % en poids sec de fibres de verre.

En variante, le matelas fibreux peut être dépourvu de fibres de verre. Dans ce cas, les fibres du matelas fibreux peuvent être exclusivement des fibres de cellulose.

Dans un mode de réalisation particulier de l'invention, le matelas fibreux comporte 46,5 % de fibres courtes, 46,5% de fibres longues et 7,5 % de fibres de verre.

L'ajout de fibres de verre dans le matelas permet d'augmenter la stabilité dimensionnelle du support, notamment lors des étapes de formation de la feuille et de séchage de celle-ci et/ou lors de l'utilisation ultérieure du support (passage du support au travers de bains multiples, séchages séquentiels, ...). Dans des applications de circuits imprimés par exemple réalisés par procédés soustractifs chimiques, il est très important de pouvoir assurer un alignement des motifs de circuiterie entre eux pour éviter tout court-circuit ou problème d'insertion des composants sur le circuit imprimé.

Les fibres de verre peuvent être des fibres coupées de type E, par exemple les fibres connues sous la référence CS 1008. Les fibres de verre ont de préférence une longueur moyenne comprise entre 3 et 10 mm.

On rappelle que le verre de type E comporte de 53 à 55 % en poids de SiO₂, de 14 à 15 % en poids de Al₂O₃, de 17 à 23 % en poids de CaO, environ 1 % en poids de MgO, environ 0,8 % en poids de Na₂CO₃, de 0 à 8 % en poids de B₂O₃, environ 0,3 % en poids de Fe₂O₃ et environ 0,5 % en poids de TiO₂.

Avantageusement, le matelas fibreux comporte de 0,1 à 10 % en poids sec d'un liant, tel par exemple que du latex.

Ce liant assure la liaison entre les différents constituants du matelas fibreux et permet notamment de fixer les fibres de verre aux fibres cellulosiques. Le liant permet également de renforcer les propriétés physiques du matelas fibreux.

Il est notamment possible d'utiliser un latex anionique, tel qu'un latex acrylique, en tant que liant. De manière générale, il est possible d'utiliser tout type de latex apte à être stabilisé anionique en émulsion.

D'autres types de liants peuvent être utilisés, tels que l'alcool polyvinylique (P.V.A.), l'alginate, la gélatine, la gomme de guar, la dextrine, les dérivés cellulosiques tels que les gommes de cellulose ou carboxyméthyl cellulose (C.M.C), ou l'hydroxy méthyl cellulose (H.M.C.), les protéines (soja, ...), la caséine, la fécule native, l'amidon natif, notamment l'amidon de maïs natif, l'ester phosphorique d'amidon, l'amidon carboxyméthylé, la fécule oxydée, la fécule enzymée, l'amidon hydroxyméthylé, la carboxyméthylcellulose technique, un polymère comportant de 87 à 90 parties en poids de motif acrylate d'éthyle, de 1 à 8 parties en poids de motifs acrylonitrile, de 1 à 6 parties en poids de motif N-méthylolacrylamide et de 1 à 6 parties en poids de motif acide acrylique, un polymère comportant de 60 à 75 parties en poids de motif acrylate d'éthyle, de 5 à 15 parties en poids de motif acrylonitrile, de 10 à 20 parties en poids de motif acrylate de butyle et de 1 à 6 parties en poids de motif N-méthylolacrylamide, un polymère comportant de 60 à 65 parties en poids de motif butadiène, de 35 à 40 parties en poids de motif acrylonitrile et de 1 à 7 parties en poids de motif acide méthacrylique, un polymère comportant de 38 à 50 parties en poids de motif styrène, de 47 à 59 parties en poids de motif butadiène et de 1 à 6 parties en poids de motif méthylacrylamide, un polymère comportant de 53 à 65 parties en poids de motif styrène, de 32 à 44 parties en poids de motif butadiène et de 1 à 6 parties en poids de motif méthylacrylamide, ou un mélange de tels composés.

Le matelas fibreux peut également comporter de 0,01 à 5 % en poids sec d'un agent floculant.

L'agent floculant est de préférence un composé cationique, capable de réagir avec un liant anionique de manière à former un précipité et accroître ainsi notamment la liaison entre les fibres de verre et les fibres cellulosiques.

L'agent floculant appartient de préférence à la classe des résines polyamidoamine-epichlorohydrine (PAAE).

De manière plus générale, l'agent floculant peut également être du type sels métalliques (par exemple sels d'aluminium, de fer (II), de fer (III), de zinc et de chrome) tels que les halogénures, sulfates et phosphates, sulfate d'aluminium, polychlorure d'aluminium, aluminate de sodium et de calcium, mélange d'acide polyacrylique et de polyacrylamide, polyéthylèneimide, copolymère d'acrylamide et de β-méthacrylyloxyéthyltriméthylammonium méthylsulfate, résine polyamineépichlorhydrine et de diamine-propylméthylamine, résine polyamide-épichlorhydrine, résine polyamide-polyamine-epichlorhydrine, résine polyamide-polyamine cationique, produits de condensation d'acides sulfoniques aromatiques avec le formaldéhyde, acétate d'aluminium, formiate d'aluminium, mélange d'acétate, sulfate et formiate d'aluminium, chlorure d'aluminium, ou un mélange de ces composés.

De préférence, le liant utilisé est un latex de type ACRONAL 728 (dispersion de polymère acrylique), commercialisé par la société BASF et l'agent floculant est de type kymene 617 (résine polyamide-épichlorhydrine cationique).

Pour la réalisation du support selon l'invention, le matelas fibreux comporte également de 0,01 à 10 % en poids sec de résine fluorée, de préférence une résine fluorée cationique.

L'ajout de résine fluorée au sein du matelas fibreux permet d'augmenter de façon importante son caractère hydrophobe.

La résine fluorée est par exemple du type Asahi Guard E 61, commercialisée par la société Asahi Glass Co., LTD.

Dans un mode de réalisation particulier de l'invention, le support hydrophobe comporte un matelas fibreux dont les fibres sont constituées, en poids sec du support, de 45,8% de fibres courtes, 45,8% de fibres longues et 7,5 % de fibres de verre, le support comportant par ailleurs de 0,01 à 10 % en poids sec de résine fluorée, en particulier 0,15 % en poids sec de résine fluorée.

Dans un mode particulier de réalisation de l'invention, les constituants et les paramètres de préparation du support hydrophobe sont ajustés de telle manière que le papier du support a un grammage de 30 à 1000 g/m² en particulier supérieur à 95 g/m² (mesuré par la norme NF EN ISO 536) une épaisseur dans un intervalle de 30 à 1000 µm (mesurée par la norme NF EN ISO 534) en particulier une épaisseur de 150 µm à 155 µm. En particulier, un papier utilisable pour préparer le support selon l'invention a une main de 0,5 à 2,5 par exemple de 1,50 à 1,60.

Les caractéristiques de structure ou de fonction ainsi que les paramètres décrits ci-dessus pour des modes de réalisation particuliers de l'invention définissent individuellement l'invention ou peuvent être combinés en tout ou partie.

Le matelas fibreux peut également comporter de 0,01 à 5 % en poids sec d'un agent de collage, par exemple du type dimère alkylcétène (AKD). Un tel agent de collage est par exemple du type AQUAPEL J 206, commercialisé par la société Banner Chemicals Limited.

Un tel agent de collage permet de renforcer encore le caractère hydrophobe du matelas fibreux. Un tel agent de collage est en particulier utile lors de la fabrication du support, car il permet d'éviter que la sauce utilisée lors d'un éventuel collage en surface à l'aide d'une presse-encolleuse, en vue de réaliser l'enduit, pénètre dans le matelas fibreux. En effet, le caractère hydrophobe de la résine fluorée se développe au fur et à mesure de la fabrication du support sur une machine à papier, notamment au fur et à mesure du séchage de la feuille destinée à former le support. Le caractère hydrophobe de la résine fluorée n'est, au moment du collage en surface à l'aide d'une presse encolleuse, pas nécessairement suffisant pour éviter la pénétration de la sauce correspondante dans le matelas fibreux.

Selon une caractéristique de l'invention, l'enduit comporte un produit filmogène, comprenant par exemple un latex et/ou un alcool polyvinylique (P.V.A.).

L'enduit comporte par exemple de 0,1 à 50 % en poids sec d'un produit filmogène. Ce dernier est par exemple un latex de type ACRONAL 728, commercialisé par la société BASF.

L'utilisation d'un produit filmogène permet de recouvrir la surface externe concernée du matelas fibreux, en bouchant ses pores, de manière à constituer l'enduit.

Avantageusement, l'enduit comporte un composé styrène acrylique, par exemple de 0,01 à 10 % en poids sec d'un tel composé.

Ce composé confère un caractère hydrophobe à l'enduit du support, dans des proportions réduites par rapport à l'hydrophobicité du matelas fibreux, afin notamment de permettre le dépôt et l'adhésion d'un film de colle sur la surface externe du support.

De préférence le composé styrène acrylique est du type Baysize BMP.

L'invention concerne également un circuit imprimé comportant un support du type précité, caractérisé en ce qu'au moins une piste conductrice est formée sur la surface externe du support.

Comme indiqué précédemment, la piste conductrice peut être formée dans une couche en matériau conducteur collée ou laminée sur la surface externe du support.

En variante, la piste conductrice peut être obtenue par impression sur la surface externe du support, à l'aide d'encres conductrices, semi-conductrices et/ou isolantes.

L'invention concerne en outre un procédé de fabrication d'un support hydrophobe du type précité, caractérisé en ce qu'il comporte les étapes consistant à :
- ajouter une résine fluorée dans une pâte comportant des fibres cellulosiques,
- former un matelas fibreux homogène à l'aide de ladite pâte comportant la résine fluorée,
- recouvrir, au moins en partie, au moins une surface du matelas fibreux avec un enduit dont l'hydrophobicité est plus faible que celle du matelas fibreux.

Avantageusement, la pâte est préparée dans un pulpeur dans lequel sont mélangés des fibres cellulosiques, des fibres de verre, un liant et un produit floculant.

La pâte peut comporter :
- de 50 à 97 % en poids sec de fibres cellulosiques, de préférence 82,50 % en poids sec de fibres cellulosiques,
- de 3 à 50 % en poids sec de fibres de verre, de préférence 7, % en poids sec de fibres de verre,
- de 0,1 à 10 % en poids sec de liant, de préférence 0,75 % en poids sec de liant, et
- de 0,01 à 5 % en poids sec de produit floculant, de préférence 0,15 % en poids sec de produit floculant.

En variante, la pâte peut être dépourvue de fibres de verre. Dans ce cas, les fibres contenues dans la pâte peuvent être exclusivement des fibres de cellulose.

En outre, la résine fluorée peut être ajoutée en partie humide d'une machine à papier.

De plus, un agent de collage, par exemple du type dimère alkylcétène, peut être ajouté en partie humide de la machine à papier.

De préférence, on ajoute, en partie humide de la machine à papier, une composition comportant
- 0,01 à 10 % en poids humide de résine fluorée, de préférence 5 % en poids humide de résine fluorée, et
- de 0,01 à 5 % en poids humide d'agent de collage, de préférence 2 % en poids humide d'agent de collage.

Avantageusement, l'enduit est réalisé par encollage sur le matelas fibreux, à l'aide d'une presse-encolleuse.

Dans ce cas, la presse-encolleuse peut être alimentée à l'aide d'une sauce à déposer sur ladite surface à encoller du matelas fibreux, ladite sauce comportant
- de 0,1 à 50 % en poids humide d'un latex, de préférence 22,5 % en poids humide d'un latex,
- de 0,01 à 10 % en poids humide d'un composé styrène acrylique, de préférence 4 % en poids humide d'un composé styrène acrylique,
- de 0,1 à 50 % en poids humide d'un alcool polyvinylique, de préférence 1,8 % en poids humide d'un alcool polyvinylique.

L'invention est illustrée et d'autres détails, caractéristiques et avantages de l'invention apparaîtront à la lecture de la description suivante qui comprend un exemple de mise en oeuvre de l'invention.

Exemple : Fabrication d'un support plan hydrophobe destiné à être utilisé pour la réalisation d'un circuit imprimé.

Une pâte à papier est préparée dans un pulpeur, ladite pâte étant obtenue par mélange dans de l'eau de :
- 45,8 % en poids sec de fibres cellulosiques courtes de type Cenibra (fibres de bois issues d'eucalyptus),
- 45,8 % en poids sec de fibres cellulosiques longues, de type Sodra Black R (fibres de bois issues de résineux),
- 7,5 % en poids sec de fibres de verre de type E connues sous la référence CS 1008,
- 0,75 % en poids sec de latex de type ACRONAL 728 (liant),
- 0,15 % en poids sec de résine polyamide-épichlorhydrine cationique de type kymene 617 (agent floculant).

La pâte ainsi préparée est raffinée à 30 degrés Chopper. La composition de cette pâte est ensuite ajustée en amont de la caisse de tête d'une machine à papier, par exemple par piquage dans une tuyauterie ou dans des bacs intermédiaires.

Lors de cette étape d'ajustement de la composition de la pâte 5 % en poids humide (par rapport au poids de la pâte avant ajustement) de résine fluorée de type Asahi Guard E 61 et 2 % en poids humide d'agent de collage de type Aquapel J 206 sont ajoutés.

La pâte ainsi préparée est envoyée dans la caisse de tête d'une machine à papier puis est uniformément répartie sur une toile en mouvement d'une table plate, où elle va subir un égouttage au travers des mailles de la toile, par gravité et par aspiration à l'aide de caisses aspirantes, en vue de réaliser une feuille, comme cela est connu de l'homme du métier.

Une fois formée la feuille de papier, celle-ci traverse la section de presse de la machine à papier, puis une sécherie composée d'une série de cylindres chauffés à la vapeur, sur lesquels passe la feuille.

Lorsque l'humidité de la feuille est fortement réduite, par exemple de l'ordre de 5 %, la feuille subit un traitement d'encollage en surface par passage au travers d'une presse-encolleuse. La presse-encolleuse est par exemple formée de deux rouleaux disposés côte-à-côte horizontalement, de manière à former une cuvette alimentée par une sauce d'une composition déterminée. La feuille passe entre les rouleaux de manière à enduire ses deux faces opposées.

Ladite sauce comporte :
- environ 22,5 % en poids humide d'un latex de type ACRONAL 728,
- environ 4 % en poids humide d'un composé styrène acrylique de type Baysize BMP,
- environ 1,8 % en poids sec d'un alcool polyvinylique (P.V.A.) de type BF 17.

La feuille passe ensuite dans une section dite de post-sécherie, dans laquelle elle est à nouveau appliquée contre un ou plusieurs rouleaux chauffés à la vapeur, jusqu'à une température de l'ordre de 120°C par exemple.

A l'issue de ces différentes étapes, la feuille se présente sous la forme d'une bande continue comportant une zone interne ou à coeur formant un matelas fibreux, dont les surfaces externes sont chacune recouvertes d'un enduit.

Le support ainsi fabriqué possède une énergie de surface à coeur ou interne (énergie de surface du matelas fibreux) très faible, c'est-à-dire un caractère très hydrophobe au coeur du support. Dans le cas où ce support est trempé dans des bains chimiques agressifs, par exemple en vue de la réalisation d'un circuit imprimé, l'absorption des bains par le support est faible, même si ce support est perforé. A titre d'exemple, la reprise d'un bain de soude à 20 % de concentration (pH=13) est seulement de 6%. La reprise se définit comme le rapport entre le poids de bain absorbé sur le poids total du support avant trempage dans le bain.

Par ailleurs, l'énergie de surface externe (énergie de surface de chaque enduit du support) est moyennement faible, donnant un caractère moyennement hydrophobe en surface. Ceci permet notamment le collage d'une feuille de cuivre sur l'une des surfaces externes du support, ou le collage d'une feuille de cuivre sur chacun des deux surfaces externes dudit support.

Le support ainsi fabriqué est également imprimable, par une technique d'impression jet d'encre (imprimante de type Ceradrop) avec des encres en argent de type Sun Chemical U5714.

Le retrait au séchage à 120 °C d'un tel support est très faible, en particulier inférieur à 0,25 % dans le sens marche et dans le sens travers, ce qui est favorable notamment lors d'une étape de réticulation d'une couche de colle apposée sur le support.

Les caractéristiques d'un tel support sont les suivantes :
- Grammage : 97,8 g/m² (obtenu suivant la norme NF EN ISO 536)
- Epaisseur: 152 µm (obtenue suivant la norme NF EN ISO 534)
- Main : 1,56
- Eclatement : 3.76 kPa (obtenu suivant la norme NF Q 03.053/ISO 2758)
- Rigidité dans le sens machine: 1,23 (obtenue suivant la norme ISO 2493 / NF Q 03-048)
- Rigidité dans le sens travers : 0,85 (obtenue suivant la norme ISO 2493 / NF Q 03-048)
- Déchirure dans le sens machine : 1,06 (obtenue suivant la norme NF EN 21974)
- Déchirure dans le sens travers : 1,06 (obtenue suivant la norme NF EN 21974)
- Energie de surface du matelas fibreux (énergie de surface interne) : 12 mJ/m² (obtenue suivant le test décrit ci-dessus)
- Energie de surface de chaque enduit (énergie de surface externe) : 17,5 mJ/m² (obtenue suivant le test décrit ci-dessus).

## Revendications

1. Support plan hydrophobe, **caractérisé en ce qu'**il comporte un matelas fibreux à base de fibres cellulosiques et d'une résine fluorée conférant des propriétés hydrophobes au matelas fibreux, au moins une surface du matelas étant recouverte, au moins en partie, d'un enduit dont l'énergie de surface est supérieure à celle du matelas fibreux.

2. Support hydrophobe selon la revendication 1, **caractérisé en ce que** l'énergie de surface de l'enduit est comprise de 10 à 40 mJ/m², de préférence comprise de 15 à 30 mJ/m², plus préférentiellement de l'ordre de 17,5 mJ/m².

3. Support hydrophobe selon la revendication 1 ou 2, **caractérisé en ce que** l'énergie de surface interne du matelas fibreux est comprise de 5 à 30 mJ/m², de préférence comprise de 10 à 20 mJ/m², plus préférentiellement de l'ordre de 12 mJ/m².

4. Support hydrophobe selon l'une des revendications 1 à 3, **caractérisé en ce que** le matelas fibreux comporte des fibres cellulosiques courtes, de longueur moyenne comprise de 0,5 à 1,5 mm, telles que des fibres de bois issues d'eucalyptus, et des fibres cellulosiques longues, de longueur moyenne comprise de 1,5 à 3 mm, telles que des fibres de bois issues de résineux, plus particulièrement **en ce que** le matelas fibreux comporte de 10 à 90 % en poids sec, de préférence 45,8 % en poids sec de fibres courtes, et de 10 à 90 % en poids sec, de préférence 45,8 % en poids sec de fibres longues.

5. Support hydrophobe selon l'une des revendications 1 à 4, **caractérisé en ce que** le matelas fibreux comporte de 3 à 50 % en poids sec de fibres de verre, de préférence 7,5 % en poids sec de fibres de verre.

6. Support hydrophobe selon la revendication 1 à 5, **caractérisé en ce que** le matelas fibreux comporte de 0,1 à 10 % en poids sec d'un liant, tel par exemple que du latex, ou **en ce que** le matelas fibreux comporte de 0,01 à 5 % en poids sec d'un agent floculant.

7. Support hydrophobe selon l'une des revendications 1 à 6, **caractérisé en ce que** le matelas fibreux comporte de 0,01 à 10 % en poids sec de résine fluorée.

8. Support hydrophobe selon l'une des revendications 1 à 7, **caractérisé en ce que** le matelas fibreux comporte de 0,01 à 5 % en poids sec d'un agent de collage, par exemple du type dimère alkylcétène.

9. Support hydrophobe selon l'une des revendications 1 à 8, **caractérisé en ce que** l'enduit comporte un produit filmogène, comprenant par exemple un latex et/ou un alcool polyvinylique, et/ou **en ce que** l'enduit comporte un composé styrène acrylique.

10. Circuit imprimé comportant un support selon l'une des revendications 1 à 9, **caractérisé en ce qu'**au moins une piste conductrice est formée sur la surface externe du support.

11. Procédé de fabrication d'un support hydrophobe selon l'une des revendications 1 à 10, **caractérisé en ce qu'**il comporte les étapes consistant à :
- ajouter une résine fluorée dans une pâte comportant des fibres cellulosiques,
- former un matelas fibreux homogène à l'aide de ladite pâte comportant la résine fluorée,
- recouvrir, au moins en partie, au moins une surface du matelas fibreux avec un bain dont l'hydrophobicité est plus faible que celle du matelas fibreux.

12. Procédé selon la revendication 11, **caractérisé en ce que** la pâte est préparée dans un pulpeur dans lequel sont mélangés des fibres cellulosiques, des fibres de verre, un liant et un produit floculant, la pâte pouvant plus particulièrement comporter :
- de 50 à 97 % en poids sec de fibres cellulosiques, de préférence 82,50 % en poids sec de fibres cellulosiques,
- de 3 à 50 % en poids sec de fibres de verre, de préférence 7,5 % en poids sec de fibres de verre,
- de 0,1 à 10 % en poids sec de liant, de préférence 0,75 % en poids sec de liant, et
- de 0,01 à 5 % en poids sec de produit floculant, de préférence 0,15 % en poids sec de produit floculant.

13. Procédé selon la revendication 11 ou 12, **caractérisé en ce que** la résine fluorée est ajoutée en partie humide d'une machine à papier.

14. Procédé selon la revendication 13, **caractérisé en ce qu'**un agent de collage, par exemple du type dimère alkylcétène, est ajouté en partie humide de la machine à papier, plus particulièrement **en ce que** qu'on ajoute, en partie humide de la machine à papier, une composition comportant
- de 0,01 à 10 % en poids humide de résine fluorée, de préférence 5 % en poids humide de résine fluorée, et
- de 0,01 à 5 % en poids humide d'agent de collage, de préférence 2 % en poids humide d'agent de collage.

15. Procédé selon l'une des revendications 11 à 14, **caractérisé en ce que** l'enduit est réalisé par encollage sur le matelas fibreux, à l'aide d'une presse-encolleuse, la presse-encolleuse pouvant plus particulièrement être alimentée à l'aide d'une sauce à déposer sur ladite surface à encoller du matelas fibreux, ladite sauce comportant
- de 0,1 à 50 % en poids humide d'un latex, de préférence 22,5 % en poids humide d'un latex,
- de 0,01 à 10 % en poids humide d'un composé styrène acrylique, de préférence 4 % en poids humide d'un composé styrène acrylique,
- de 0,1 à 50 % en poids humide d'un alcool polyvinylique, de préférence 1,8 % en poids humide d'un alcool polyvinylique.

## Patentansprüche

1. Ebener, wasserabweisender Untergrund, **dadurch gekennzeichnet, dass** er eine Fasermatte aus Cellulosefasern und aus Fluorharz umfasst, welches der Fasermatte wasserabweisende Eigenschaften verleiht, wobei mindestens eine Seite der Matte zumindest teilweise mit einem Überzug beschichtet ist, dessen Oberflächenspannung größer als die der Fasermatte ist.

2. Wasserabweisender Untergrund nach Anspruch 1, **dadurch gekennzeichnet, dass** die Oberflächenspannung des Überzugs zwischen 10 und 40 mJ/m², vorzugsweise aber zwischen 15 und 30 mJ/m² und im Idealfall 17,5 mJ/m² beträgt.

3. Wasserabweisender Untergrund nach Anspruch 1 und 2, **dadurch gekennzeichnet, dass** die innere Oberflächenspannung der Fasermatte zwischen 5 und 30 mJ/m², vorzugsweise aber zwischen 10 und 20 mJ/m², und im Idealfall 12 mJ/m² beträgt.

4. Wasserabweisender Untergrund nach einem der Ansprüche 1 bis 3, **dadurch gekennzeichnet, dass** die Fasermatte kurze Cellulosefasern mit einer durchschnittlichen Länge von 0,5 bis 1,5 mm, wie zum Beispiel aus dem Eukalyptusbaum stammende Holzfasern, enthält, sowie lange Cellulosefasern mit einer durchschnittlichen Länge von 1,5 bis 3 mm, wie zum Beispiel aus harzhaltigen Pflanzen stammende Holzfasern, und insbesondere dadurch, dass die Fasermatte ein Trockengewicht von 10 bis 90 %, vorzugsweise aber 45,8 % an kurzen Fasern, und ein Trockengewicht von 10 bis 90 %, vorzugsweise aber 45,8 %, an langen Fasern aufweist.

5. Wasserabweisender Untergrund nach einem der Ansprüche 1 bis 4, **dadurch gekennzeichnet, dass** die Fasermatte ein Trockengewicht von 3 bis 50 %, vorzugsweise aber 7,5 % an Glasfasern aufweist.

6. Wasserabweisender Untergrund nach Anspruch 1 bis 5, **dadurch gekennzeichnet, dass** die Fasermatte ein Trockengewicht von 0,1 bis 10 % an Bindemittel, wie zum Beispiel Latex, enthält, oder dadurch, dass die Fasermatte ein Trockengewicht von 0,01 bis 5 % an Flockungsmittel enthält.

7. Wasserabweisender Untergrund nach einem der Ansprüche 1 bis 6, **dadurch gekennzeichnet, dass** die Fasermatte ein Trockengewicht von 0,01 bis 10 % an Fluorharz enthält.

8. Wasserabweisender Untergrund nach einem der Ansprüche 1 bis 7, **dadurch gekennzeichnet, dass** die Fasermatte ein Trockengewicht von 0,01 bis 5 % an Leimungsmittel, wie zum Beispiel Alkylketendimer, enthält.

9. Wasserabweisender Untergrund nach einem der Ansprüche 1 bis 8, **dadurch gekennzeichnet, dass** der Überzug einen Filmbildner enthält, der beispielsweise Latex und/oder Polyvinylalkohol umfasst, und/oder dadurch, dass der Überzug eine Styrol/Acryl-Verbindung enthält.

10. Leiterplatte, die einen Untergrund gemäß einem der Ansprüche 1 bis 9 enthält, **dadurch gekennzeichnet, dass** mindestens eine Leiterbahn auf der äußeren Seite des Untergrunds gebildet wird.

11. Herstellungsverfahren für einen wasserabweisenden Untergrund nach einem der Ansprüche 1 bis 10, **dadurch gekennzeichnet, dass** es Schritte umfasst, die darin bestehen:
- ein Fluorharz zu einer Masse hinzuzufügen, die Cellulosefasern enthält,
- mithilfe besagter Masse, welche das Fluorharz enthält, eine gleichmäßige Fasermatte zu bilden,
- mindestens eine Seite der Fasermatte zumindest teilweise mit einer Tauchlösung zu bedecken, deren Hydrophobizität geringer ist, als die der Fasermatte.

12. Verfahren nach Anspruch 11, **dadurch gekennzeichnet, dass** die Masse in einem Breibereiter zubereitet wird, in dem Cellulosefasern, Glasfasern, ein Bindemittel und ein Flockungsmittel miteinander vermischt werden, wobei die Masse insbesondere Folgendes enthalten kann:
- ein Trockengewicht von 50 bis 97 % an Cellulosefasern, vorzugsweise aber ein Trockengewicht von 82,50 % an Cellulosefasern,
- ein Trockengewicht von 3 bis 50 % an Glasfasern, vorzugsweise aber ein Trockengewicht von 7,5 % an Glasfasern,
- ein Trockengewicht von 0,1 bis 10 % an Bindemittel, vorzugsweise aber ein Trockengewicht von 0,75 % an Bindemittel, und
- ein Trockengewicht von 0,01 bis 5 % an Flockungsmittel, vorzugsweise aber ein Trockengewicht von 0,15 % an Flockungsmittel.

13. Verfahren nach Anspruch 11 oder 12, **dadurch gekennzeichnet, dass** das Fluorharz teilweise in der Pressenpartie einer Papiermaschine hinzugefügt wird.

14. Verfahren nach Anspruch 13, **dadurch gekennzeichnet, dass** ein Leimungsmittel, wie zum Beispiel ein Alkylketendimer, in der Pressenpartie einer Papiermaschine hinzugefügt wird, und insbesondere dadurch, dass man in der Pressenpartie der Papiermaschine folgende Zusammensetzung hinzufügt:
- ein Feuchtgewicht von 0,01 bis 10 % an Fluorharz, vorzugsweise aber ein Feuchtgewicht von 5 % an Fluorharz, und
- ein Feuchtgewicht von 0,01 bis 5 % an Leimungsmittel, vorzugsweise aber ein Feuchtgewicht von 2 % an Leimungsmittel.

15. Verfahren nach einem der Ansprüche 11 bis 14, **dadurch gekennzeichnet, dass** der Überzug mithilfe einer Leimpresse durch Aufleimen auf der Fasermatte hergestellt wird, wobei die Leimpresse insbesondere mithilfe einer auf die besagte Verleimungsfläche der Fasermatte aufzutragenden Mischung befüllt werden kann, wobei besagte Mischung Folgendes enthält:
- ein Feuchtgewicht von 0,01 bis 50 % an Latex, vorzugsweise aber ein Feuchtgewicht von 22,5 % an Latex,
- ein Feuchtgewicht von 0,01 bis 10 % an einer Acryl/Styren-Verbindung, vorzugsweise aber eine Feuchtgewicht von 4 % an einer Acryl/Styren-Verbindung,
- ein Feuchtgewicht von 0,01 bis 50 % an Polyvinylalkohol, vorzugsweise aber ein Feuchtgewicht von 1,8 % an Polyvinylalkohol.

## Claims

1. A hydrophobic planar support, **characterized in that** it comprises a fibrous mat made from cellulosic fibers and a fluororesin which confers hydrophobic properties to the fibrous mat, at least one surface of the mat being at least partially covered with a coating, the surface energy of which is greater than that of the fibrous mat.

2. A hydrophobic support according to claim 1, **characterized in that** the surface energy of the coating is in the range of from 10 to 40 mJ/m², preferably in the range of from 15 to 30 mJ/m², more preferably of the order of 17.5 mJ/m².

3. A hydrophobic support according to claim 1 or 2, **characterized in that** the internal surface energy of the fibrous mat is in the range of from 5 to 30 mJ/m², preferably in the range of from 10 to 20 mJ/m², more preferably of the order of 12 mJ/m².

4. A hydrophobic support according to one of claims 1 to 3, **characterized in that** the fibrous mat comprises short cellulosic fibers, having an average length of 0.5 to 1.5mm, such as wood fibers from eucalyptus, and long cellulosic fibers, having an average length of 1.5 to 3mm, such as wood fibers from softwood, and more particularly **in that** the fibrous mat comprises from 10 to 90% by dry weight, preferably 45.8% by dry weight of short fibers, and from 10 to 90% by dry weight, preferably 45.8% by dry weight of long fibers.

5. A hydrophobic support according to one of claims 1 to 4, **characterized in that** the fibrous mat comprises from 3 to 50% by dry weight of glass fibers, preferably 7.5% by dry weight of glass fibers.

6. A hydrophobic support according to one of claims 1 to 5, **characterized in that** the fibrous mat comprises from 0.1 to 10% by dry weight of a binder, such as for example latex, or **in that** the fibrous mat comprises from 0.01 to 5% by dry weight of a flocculating agent.

7. A hydrophobic support according to one of claims 1 to 6, **characterized in that** the fibrous mat comprises from 0.01 to 10% by dry weight of fluororesin.

8. A hydrophobic support according to one of claims 1 to 7, **characterized in that** the fibrous mat comprises from 0.01 to 5% by dry weight of a sizing agent, for example of the alkyl ketene dimer type.

9. A hydrophobic support according to one of claims 1 to 8, **characterized in that** the coating comprises a film-forming product, comprising for example latex and/or polyvinyl alcohol, and/or **in that** the coating comprises a styrene-acrylic compound.

10. A printed circuit comprising a support according to one of claims 1 to 9, **characterized in that** at least one conductive track is formed on the outer surface of the support.

11. A method for manufacturing a hydrophobic support according to one of claims 1 to 10, **characterized in that** it comprises the steps of:
- adding a fluororesin into a pulp comprising cellulosic fibers,
- forming a homogeneous fibrous mat using said pulp comprising the fluororesin,
- at least partially covering, at least one surface of the fibrous mat with a coating bath, the hydrophobicity of which is lower than that of the fibrous mat.

12. A method according to claim 11, **characterized in that** the pulp is prepared in a pulper, in which cellulosic fibers, glass fibers, a binder and a flocculating agent are mixed, in particular the pulp comprising:
- from 50 to 97% by dry weight of cellulosic fibers, preferably 82.50% by dry weight of cellulosic fibers,
- from 3 to 50% by dry weight of glass fibers, preferably 7.5% by dry weight of glass fibers,
- from 0.1 to 10% by dry weight of a binder, preferably 0.75% by dry weight of a binder, and
- from 0.01 to 5% by dry weight of a flocculating agent, preferably 0.15% by dry weight of a flocculating agent.

13. A method according to claim 11 or 12, **characterized in that** the fluororesin is added at the wet end of a paper machine.

14. A method according to claim 13, **characterized in that** a sizing agent, for example of the alkyl ketene dimer type, is added at the wet end of the paper machine, more particularly **in that** a composition comprising
- from 0.01 to 10% by wet weight of fluororesin, preferably 5% by wet weight of fluororesin, and
- from 0.01 to 5% by wet weight of the sizing agent, preferably 2% by wet weight of the sizing agent, is added at the wet end of the paper machine.

15. A method according to one of claims 11 to 14, **characterized in that** the coating is applied by sizing on the fibrous mat using a size press, in particular the size press being fed with a coating formulation to be deposited onto said surface to be sized of the fibrous mat, said coating formulation comprising
- from 0.1 to 50% by wet weight of latex, preferably 22.5% by wet weight of latex,
- from 0.01 to 10% by wet weight of a styrene-acrylic compound, preferably 4% by wet weight of a styrene-acrylic compound,
- from 0.1 to 50% by wet weight of a polyvinyl alcohol, preferably 1.8% by wet weight of a polyvinyl alcohol.
